# EUROPEAN PATENT APPLICATION

(11) **EP 4 546 048 A1**
(43) Date of publication of application: **30.04.2025**
(21) Application number: 23205186.2
(22) Date of filing: 23.10.2023
(51) Int. Cl.: G03F 1/84, G03F 1/76, G03F 7/20, G01N 21/956

(54) **SYSTEM AND METHOD FOR EVALUATING A SUBSTRATE SUCH AS A LITHOGRAPHIC MASK USING AN ILLUMINATION TRIGGER SIGNAL AND AN IMAGE TRIGGER SIGNAL**

(71) Applicant: Mycronic AB, 183 03 Täby (SE)
(72) Inventor: Walther, Jonas, 169 37 Solna (SE)
(74) Representative: AWA Sweden AB

(57) **Abstract**

An evaluation system is provided for evaluating a substrate. The evaluation system comprises at least one optical arrangement configured to have a focal point at a target position of the substrate, an image capturing device configured to capture an image of the target position of the substrate via the at least one optical arrangement, an illumination unit configured to illuminate the target position of the substrate via the at least one optical arrangement, and a control unit configured to perform an imaging sequence. The imaging sequence comprises an image trigger signal and an illumination trigger signal, wherein the control unit is configured to send the image trigger signal to the image capturing device and the illumination trigger signal to the illumination unit. The image capturing device is configured to receive an image trigger signal and capture an image based on the image trigger signal. The illumination unit is configured to receive the illumination trigger signal and to illuminate the substrate based on the illumination trigger signal.

## Description

### TECHNICAL FIELD

The present invention generally relates to the field of optical microlithography. In particular, the present invention relates to an evaluation system for use when evaluating a substrate processed by optical microlithography.

### BACKGROUND

Today, the need for and production of electronic components are ever-increasing. One of the most common methods for efficient and accurate manufacturing of electrical components, such as semi-conductors and displays, is optical microlithography, wherein an optical beam transfers a pattern from a photo mask substrate onto a coated wafer to create e.g. a display of the wafer. Optical microlithography can create very small patterns, down to nanometer size, and provide a precise control of the design of the pattern. Due to the order of magnitude of the size, and the required precision of the printed pattern in these components, the accuracy of the photo mask substrate is crucial. Furthermore, the accuracy of the printed pattern, and thereby the accuracy of the photo mask substrate, determines the performance of the electronic component that is manufactured.

In the production of photo mask substrates, which also are types of patterned substrates, errors may occur due to inadequate calibrations or disturbances, such as vibrations or thermal instabilities. The errors or defects in a photo mask substrate may lead to manufacturing errors of electronic components and directly affect the performance, functionality and reliability of the electronic components. This may result in increased costs and production losses.

Early detection of errors or defects in a patterned substrate, such as a photo mask substrate, can reduce costs and ensure performance of manufactured electronic components. Furthermore, by evaluating a patterned substrate it enables calibration of the production process of the patterned substrate. In order to ensure the accuracy of a substrate it is needed an high-resolution and reliable way of evaluating a substrate.

### SUMMARY

It is an object of the present invention to provide improved techniques for evaluating a substrate. This and other objects are achieved by an evaluation system and method for evaluating having the features in the independent claims. Preferred embodiments are defined in the dependent claims.

In a first aspect of the inventive concept, there is provided an evaluation system for evaluating a substrate. The evaluation system comprises at least one optical arrangement configured to have a focal point at a target position of the substrate, an image capturing device configured to capture at least one image of the target position of the substrate via the at least one optical arrangement, an illumination unit configured to illuminate the target position of the substrate via the at least one optical arrangement, and a control unit configured to perform an imaging sequence, wherein the imaging sequence comprises at least one image trigger signal and at least one illumination trigger signal. The control unit is configured to send the at least one image trigger signal to the image capturing device and the at least one illumination trigger signal to the illumination unit. The image capturing device is configured to receive the at least one image trigger signal and capture at least one image based on the at least one image trigger signal. The illumination unit is configured to receive the at least one illumination trigger signal and to illuminate the substrate based on the at least one illumination trigger signal.

The substrate may comprise a flat surface, sheet and/or a plate. For example, the substrate may comprise a plate/sheet. The substrate may comprise a material based on the chemical compound silica, such as, glass, Quartz or Soda-lime glass. The substrate may be partially light-transmissive. The substrate may comprise at least one coating or layer. The substrate may comprise at least one patterned coating or layer. The surface of the substrate may be provided with a coating or a printed pattern. The substrate may be a mask or a photo mask. The substrate may be arranged/placed in an XY-plane, i.e. in a two dimensional plane extending in an X-direction and an Y-direction. The substrate may be arranged/placed on a movable or static platform/stage in the XY-plane. The substrate may be arranged on/attached in a movable or static holder/attachment unit in the XY-plane. The platform, stage, holder and/or attachment unit may be light-transmissive or opaque. The platform, stage, holder and/or attachment may comprise an opening, through which light may travel in order to illuminate the substrate.

The at least one optical arrangement is configured to have a focus/focal point at a target position of the substrate. The target position may be a position of the substrate. The target position may be defined by XY-coordinates in the XY-plane. The target position may be a position of the substrate that is desired to be evaluated. The at least one optical arrangement may be configured to allow the image capturing device to take an image at the target position. It is to be understood that the at least one optical arrangement may be configured to allow the evaluation system to take an image around/adjacent to/in the vicinity of the target position. For example, the at least one optical arrangement may be configured to direct/transmit/modulate light originating from the target position, and around the target position, to reach the image capturing device. The at least one optical arrangement may be configured to optimize image capturing and/or illumination at very small target position/features, e.g. in the micrometer or nanometer range. The at least one optical arrangement may comprise one or more optical elements/components/parts. The one or more optical elements may be lenses, filters, windows, optical flats, prisms, polarizers, beam-splitters, wave-plates, fiber optics and/or mirrors. The at least one optical arrangement may be arranged between the substrate and at least one of the image capturing device and the illumination unit. The at least one optical arrangement may comprise an illumination part and an imaging part. The illumination part of the at least one optical arrangement may be arranged to have an illumination optical path for directing/transmitting the illuminating light from the illumination unit to the target position. The imaging part of the at least one optical arrangement may be arranged to have an imaging optical path for directing light from the target position to the image capturing device, such as scattered/reflected//transmitted light from the illumination. The illumination optical path and the imaging optical path may be at least partly integrated, i.e. at least a part of the at least one optical arrangement are used for both the illumination and the image capturing. In an example, the evaluation system may comprise a first optical arrangement and a second optical arrangement. The first optical arrangement may comprise an illumination part and the second optical arrangement may comprise an imaging part. Then the illumination optical path and the imaging optical path may be separated.

The image capturing device is configured to capture at least one image. The image capturing device is configured to capture at least one image of a target position of a substrate via the at least one optical arrangement. By the wording "via the at least one optical arrangement", it is here meant that the at least one image of the target position is captured through the at least one optical arrangement, i.e. the image capturing is facilitated by the at least one optical arrangement. The image capturing device may be configured to capture at least one image of a target position of a substrate via the imaging part of the at least one optical arrangement. The image capturing device may capture an image of a target position of a substrate through the imaging optical path. The image capturing device may for example be any image sensor or camera. The image capturing device and the at least one optical arrangement may together form an image capturing system. The image capturing system may have a resolution in the micrometer and/or nanometer range, i.e. capture/distinguish features in the micrometer and/or nanometer scale.

The illumination unit may be configured to emit light. The illumination unit may be configured to emit monochromatic or coherent light. The illumination unit is configured to illuminate a target position of a substrate via the at least one optical arrangement. By the wording "via the at least one optical arrangement", it is here meant that the illumination/emitted light is guided/directed through the at least one optical arrangement to the target position, i.e. the illumination is facilitated by the at least one optical arrangement. The illumination unit may be configured to illuminate a target position of a substrate via the illumination part of the at least one optical arrangement. Light from the illumination unit may follow the illumination optical path such that the light is transmitted to illuminate the target position of the substrate. The illumination unit and the at least one optical arrangement may together form an illumination system. The illumination system may be configured to illuminate features in the micrometer and/or nanometer scale.

The control unit is configured to perform an imaging sequence. The imaging sequence may be a sequence/series of events/movements that follow each other, e.g. in a particular order. An event may be sending of an image trigger signal, or sending of an illumination trigger signal. A movement may be a movement of a part of the evaluation system, e.g. the at least one optical arrangement or movement of the substrate. An imaging sequence comprises at least one image trigger signal and at least one illumination trigger signal. The at least one image trigger signal may order/provide instructions/trigger the image capturing device to take one or more images of the target position. For example, taking one image for a first time, i.e. during a first time window, upon receiving an image trigger signal. The at least one illumination trigger signal may order/provide instructions/trigger the illumination unit to illuminate the target position. For example, illuminating for a second time, i.e. during a second time window, upon receiving an illumination trigger signal. An image sequence may comprise a single image trigger signal or a series of multiple image trigger signals. An image sequence may comprise a single illumination trigger signal or a series of multiple illumination trigger signals. An imaging sequence may comprise different numbers of image trigger signals and illumination trigger signals depending on the type of evaluation of the substrate. The control unit is configured to send at least one image trigger signal to the image capturing device. The image capturing device is configured to receive the at least one image trigger signal and capture an image of a target position of a substrate based on the image trigger signal. The control unit is configured to send at least one illumination trigger signal to the illumination unit. The illumination unit is configured to receive the at least one image trigger signal and illuminate a target position of a substrate based on the illumination trigger signal.

The control unit may be connected to the image capturing device and the illumination unit using for example a cable and/or wireless alternatives. The control unit and the image capturing device may be connected such that the control unit can send at least one image trigger signal to the image capturing device and receive at least one captured image by the the image capturing device. The control unit and the illumination unit may be connected such that the control unit can send at least one illumination trigger signal to the illumination unit. The control unit may comprise processing circuitry, analog and/or digital. The control unit may comprise a processing unit /computer.

The evaluation system for evaluating a substrate according to the first aspect of the present invention is advantageous since it provides an evaluation system with coordinated image capturing and illumination of a substrate in order to generate data that may be used for evaluating a substrate. The present invention allows evaluation of a substrate by at least one of light reflection and light transmission analysis. The evaluation system illuminates a substrate and may detect reflected and/or transmitted light, by the image capturing device, in order to evaluate the substrate. Furthermore, the present invention provides improved control of illumination and image capturing of a target position of a substrate. The imaging sequence may be customized and thus the evaluation system is adaptable to different types of evaluation. The evaluation system provides an improved evaluation of a substrate, especially for features of the substrate at micrometer and/or nanometer scale.

According to an embodiment of the present invention, the at least one optical arrangement may comprise an objective lens. The evaluation system may comprise at least one position sensor configured to generate positional data indicating a position of the objective lens relative to the substrate. The control unit may be configured to receive the positional data from the at least one position sensor and perform the imaging sequence based on the positional data. It is to be understood that the imaging sequence may be based partly on the positional data, and not exclusively based on the positional data. The objective lens may be an optical element in the at least one optical arrangement arranged closest to the substrate. The objective lens may be arranged adjacent the substrate. The objective lens may comprise a final lens or a field lens, the types which may be found in mask writers. The objective lens may be configured to focus and/or gather light on/from the target position of the substrate. The at least one position sensor may be configured to generate positional data indicating a position of the objective lens relative to the substrate. The at least one position sensor may be configured to generate positional data indicating a position of the substrate and/or a position of the platform/holder where the substrate may be arranged/placed. The positional data may indicate a first position of the objective lens and/or a second position of the substrate, and/or the platform/holder on/in which the substrate is arranged. The positional data may comprise positions defined in a plane, e.g. X-coordinates and Y-coordinates in the XY-plane. The control unit may be connected to the at least one positional sensor, for example by cable or wireless alternatives. The control unit may receive the positional data from the at least one positional sensor. The control unit may be configured to perform an imaging sequence based on the positional data. If the positional data indicates a position of the objective lens relative to the substrate that corresponds to a target position to be evaluated, the control unit may be configured to perform an imaging sequence at that position. If the positional data indicates a position of the substrate or a position of the platform/holder where the substrate is arranged/placed that corresponds to a target position to be evaluated, the control unit may be configured to perform an imaging sequence at that position. In an embodiment, the positional data comprises a reference to the at least one image, such that the positional data may be associated with the at least one image.

The image capturing may be combined with the positional data, such that the image capturing may be synchronized/associated/linked with the positional data. For example, an image may be captured/taken and positional data may be recorded at some point during the capturing of said image, and/or during the whole capturing of the image. The positional data may be associated with the image(s) taken at the same time. The present embodiment is advantageous in that it further improves evaluation performance. Furthermore, this allows an imaging sequence to be customized for a specific position on the substrate, for example a target position, which provides an improved performance and accuracy of the evaluation system. In other words, the evaluation system, e.g. the control unit, may be configured to perform an imaging sequence and/or send at least one image trigger signal and/or at least one illumination trigger signal based on the positional data. In an embodiment, the control unit is configured to compare the positional data with a predetermined set of positions to determine when to perform an imaging sequence and/or send at least one image trigger signal and/or at least one illumination trigger signal.

According to an embodiment of the present invention, the at least one position sensor may comprise at least one of an interferometer and an encoder. An interferometer may be any device that extract information from interference, here in order to determine/measure relative displacement and/or absolute distances of one or more objects. The interferometer may be configured to determine/measure distances in different directions, e.g. in the X-direction and in the Y-direction of an XY-plane. The interferometer may be configured to determine/measure the position of the objective lens relative to the substrate and/or the position of the objective lens and/or the position of the substrate. An encoder may be any device configured to generate positional data based on at least one mechanical indication. For example, the encoder may comprise a device configured to measure a mechanical position, such as a distance from a point of origin. In a preferred embodiment, the at least one position sensor comprises both an interferometer and an encoder.

Using an interferometer and/or an encoder as the at least one position sensor provides improved precision and accuracy in determining a position of objects such as the objective lens and/or the substrate. By extension, an improved accuracy of the determination of positions provides an improved accuracy of the evaluation system.

According to an embodiment of the present invention, the control unit may be configured to run a timer. The control unit may be configured to be triggered to send at least one of the at least one image trigger signal and the at least one illumination trigger signal based on the timer. The timer may be a high-resolution timer. The timer may be a clock. The timer may be configured to count in fixed intervals of time. The timer may be configured to produce pulses at regular intervals in time. The timer may be configured to control a sequence of events or repeat or initiate an event at a predetermined point or interval in time. An imaging sequence may be based on the timer. The at least one image trigger signal in an imaging sequence may be based on the timer. The at least one illumination trigger signal in an imaging sequence may be based on the timer. A sequence or series of image trigger signals and illumination trigger signals may be based on the timer such that the trigger signals are scheduled/arranged/organized/sent at different predetermined points and/or intervals in time. The control unit may be configured to run the timer and thereby perform an imaging sequence based on the timer. The control unit may be configured to send at least one image trigger signal at a predetermined point or interval in time based on the timer. The timer may be comprised in the control unit. The control unit may be configured to send at least one illumination trigger signal at a predetermined point or interval in time. The control unit may be configured to send a sequence or series of image trigger signals and illumination trigger signals at different predetermined points or intervals in time.

An imaging sequence may be performed based on the timer, and thereby the image capturing and illumination may be performed based on time. The timer and positions on the substrate may be synchronized. Actual positions on the substrate can be combined with the images captured at a certain time or time interval. Thereby an improved accuracy of the evaluation system may be provided.

In an example, an image may be taken at a certain time set by the timer, and illumination may be done at a certain time set by the timer, wherein there is a synchronization between the image capturing and the illumination to improve the quality of image. It is to be understood that the image may be taken during a certain time interval, i.e. a certain time may also mean a certain time interval. Further, positional data indicating a position of the objective lens and/or the substrate may be synchronized with at least one of the image capturing device and the illumination unit, such that the evaluation system may generate images, improved by synchronized illumination, and generate positional data related to the images. Hence, the evaluation system may generate images of one or more target positions, and positional data indicating a position of at least one of the objective lens and the substrate, or indirectly via a platform/holder on/in which the substrate is arranged, wherein the image capturing, the illumination and the positional data is correlated/associated/linked e.g. in time.

According to an embodiment of the present invention, the control unit may be configured to receive a position sequence comprising a set of target positions, and wherein the timer may be based on the position sequence.

A position sequence may comprise at least one target position on a substrate. The position sequence may comprise a set of target positions on a substrate, wherein the target positions correspond to positions on the substrate to be evaluated. The position sequence may comprise a set of target positions, where the target positions are XY-coordinates in the XY-plane where the substrate may be arranged/placed. The control unit may be configured to receive the position sequence by user input, and/or the position sequence may be stored beforehand. The control unit may be configured to run the timer based on the position sequence. In other words, the control unit may be configured to initiate the timer at certain positions. If, for example, the positional data indicates a target position in the position sequence, the control unit may be configured to run the timer and thereby perform an imaging sequence based on the timer. That is, the control unit may be configured to send at least one image trigger signal and/or at least one illumination trigger signal based on the timer, wherein the timer may be initiated by reaching a position in the position sequence. The evaluation system may be configured to move the substrate and/or the at least one optical arrangement. By moving between the target positions in the position sequence, the control unit may run the timer at each target position in the position sequence. Thereby an imaging sequence may be performed at each target position in the position sequence.

This may provide an improved control and synchronization of image capturing and illumination with positioning of the substrate. Furthermore, evaluation of multiple target positions on the substrate by performing customized imaging sequences at each target position is enabled/provided/allowed. By using an order-list, such as the combination of the position sequence and the synchronization of the image capturing, illumination and positional data, to sequentially control the image capturing device and the illumination unit it is possible to create a fast rough measurement with position-based order-list and a moving platform/stage/holder on/in which the substrate is arranged. The sequence would then be a whole row or column of marks with a position and an image trigger signal and an illumination trigger signal for each mark and a servo log for the whole row or column. A position-based sequence could also be relevant for an inspection tool with line-scan camera.

According to an embodiment of the present invention, the at least one image trigger signal may comprise an image window signal, and the at least one illumination trigger signal may comprise an illumination window signal. When using the wording "window signal", it hereinafter refers to both the image window signal and the illumination window signal. A window signal may be defined over an interval of time. The window signal may be considered zero-valued outside of its defined time interval. An image window signal may be defined as the time interval during which an image of a target position on the substrate is captured. An illumination window signal may be defined as the time interval during which a target position on the substrate is illuminated. For example, a first image trigger signal may span over a first interval of time and a first illumination trigger signal may span over a second interval of time, wherein the image capturing device is configured to capture an image over the first interval when upon receiving the first image trigger signal, and the illumination unit is configured to illuminate during the second interval upon receiving the first illumination trigger signal.

The present embodiment is advantageous in that an image may be captured during an interval, instead of at a single point in time, in order to generate an image that can capture variations, such as movements of the substrate and thus the features in the image. For example, the substrate may be moving back and forth in one or more directions, i.e. shaking. This may be captured with a window signal that can capture e.g. one or more periods of the movement. In other words, an image may be captured/generated that is an average of the target position/substrate during the time interval. The present embodiment also provides an evaluation system which provides illumination over an interval of time by sending an illumination window signal. This may further improve the quality of the evaluation of the substrate since it may provide a stable illumination across an interval of time. The combination of having a window image trigger signal and a window illumination trigger signal is especially advantageous.

According to an embodiment of the present invention, the image window signal and illumination window signal may at least partially overlap in time. The image capturing device may thus be configured to capture at least one image over a first time interval, defined by the image window signal, and the illumination unit may be configured to illuminate over a second time interval, defined by the illumination window signal. Further, the image capturing device may be configured to capture an image during at least partly the same time interval as the illumination unit is configured to illuminate. The image window signal may be completely overlapped in time by the illumination window signal, meaning that the time interval where the image window signal is defined may be completely included in the time interval where the illumination window signal is defined. The illumination window signal may be completely overlapped in time by the image window signal, meaning that the time interval where the illumination window signal is defined may be completely included in the time interval where the image window signal is defined. The image window signal may be partially overlapped in time by the illumination window signal. Then the time interval where the image window signal is defined may be partially overlapped by the time interval where the illumination signal is defined.

The present embodiment is advantageous in that image capturing and illumination occur at least partly during the same time. This may improve the image properties, e.g. by increased contrast, which in turn allows for improved evaluation. Furthermore, depending on the type of evaluation, different combinations of illumination and image capturing may be made. A target position on the substrate may be illuminated during the whole image capturing, that is, the illumination window signal completely overlaps the image window signal. A target position on the substrate may be illuminated during a part of the image capturing, that is, the illumination window signal partly overlaps the image window signal. By this the imaging sequence may be customized in an advantageous manner to provide a desired type of evaluation.

According to an embodiment of the present invention, the illumination unit may comprise a laser.

According to an embodiment of the present invention, the evaluation system may comprise at least one secondary sensor. The control unit may be configured to receive sensor data from the at least one secondary sensor. The at least one secondary sensor may comprise at least one of a pneumatic sensor, an optical sensor, an inductive sensor, an accelerometer and a temperature sensor. The at least one secondary sensor may be configured to generate sensor data. The at least one secondary sensor may be connected to/arranged on at least one of the at least one optical arrangement, the image capturing device, the illumination unit, the position sensor and the platform/holder on/in which the substrate may be arranged/placed. For example, a secondary sensor may be arranged on the at least one optical arrangement and be configured to measure a temperature at, and/or of, the at least one optical arrangement/objective lens, or a position of the objective lens. The pneumatic sensor may be a mass sensor, a volume sensor or a flow rate sensor. The pneumatic sensor may for example be configured to measure a flow rate of a gas. The inductive sensor may for example be configured to measure a position of an object. The accelerometer may for example be configured to detect and/or measure mechanical disturbances. The temperature sensor may for example be configured to measure and/or detect thermal disturbances or thermal changes. The control unit may be connected to the at least one of an pneumatic sensor, an optical sensor, an inductive sensor, an accelerometer and a temperature sensor using for example a cable and/or wireless alternatives. In an example, the sensor data may comprise a first reference to the at least one image. Further, the sensor data may comprise a second reference to positional data, generated by the at least one position sensor, related to the at least one image. In other words, the sensor data may comprise a reference to at least one of the positional data and the at least one image.

The present embodiment is advantageous in that the evaluation system provides sensor data that can be associated with the at least one image, in order to provide improved evaluation of the substrate. In other words, the evaluation system may provide an evaluation based a combination of information from the at least one image and the at least one secondary sensor.

According to an embodiment of the present invention, the evaluation system may comprise a data storage for storing evaluation data. The evaluation data may comprise at least one of the positional data, the sensor data, the at least one captured image, and log data of the at least one image trigger signal and the at least one illumination trigger signal. The data storage may be a computer readable storage medium. The stored evaluation data may be used to perform postprocessing and analysis of the data.

This enables a traceable high-resolution logging of the positional data, the sensor data, the at least one captured image and the log data of the at least one image trigger signal and the at least one illumination trigger signal, e.g. in real-time. Hence, the at least one image, the positional data and the sensor data may be stored in real-time, e.g. with a reference between the different data sets to create a data log of associated data. By storing the evaluation data, postprocessing of evaluation data can be performed and more complex methods of determining where the at least one image was captured are allowed. Further, the present embodiment is advantageous in that processing of the data is possible after the imaging sequence is done, allowing further processing to improve the evaluation of the substrate.

According to an embodiment of the present invention, the evaluation system may be configured to determine at least one of a parameter and a condition of the substrate based on the evaluation data. The control unit may be configured to determine the parameter and/or the condition. The evaluation system may comprise a second control unit configured to determine the parameter and/or the condition. The determined parameter and/or condition of the substrate may indicate the quality of the substrate or accuracy at which the substrate was manufactured. The parameter may be any metric that describes the substrate, or at least a part of the substrate, e.g. a dimension and/or a shape of the substrate. The condition may be an indication of the overall condition/status of the substrate. The condition may be based at least partially on the parameter.

The present embodiment is advantageous in that the evaluation system provides information on the quality of the substrate, and/or of any defects and/or any inaccuracies. This allows improved evaluation of the substrate.

According to an embodiment of the present invention, the evaluation system may be configured to generate at least one processed image based on at least one of the evaluation data, the parameter and the condition. A processed image may be a processed version of the at least one image, e.g. to improve the captured image and/or to enhance certain characteristics in the captured image. The control unit may be configured to generate at least one processed image based on at least one of the evaluation data, the parameter and the condition. In an embodiment the evaluation system comprises a second control unit configured to generate at least one processed image based on at least one of the evaluation data, the parameter and the condition. The second control unit may be arranged externally from the rest of the evaluation system, e.g. in a computer for post-processing.

The present embodiment is advantageous in that the evaluation system may provide processed images that allows for improved evaluation of the substrate.

According to an embodiment of the present invention, the evaluation system may be configured to compare the evaluation data with predetermined data and generate comparison data, and to determine at least one of a parameter and a condition of the substrate based on the comparison data. Predetermined data may be reference data related to the substrate that is being evaluated. Predetermined data may for example comprise data indicating an accepted accuracy of the substrate being evaluated.

The present embodiment is advantageous in that the evaluation system may provide an improved and/or more accurate evaluation of the substrate. By comparing the evaluation data with predetermined data, the detectability of changes/defects may be increased, and it is also possible to see changes over time.

According to an embodiment of the present invention, the at least one optical arrangement may comprise a first optical arrangement arranged on a first side of the substrate, wherein the image capturing device may be configured to capture the at least one image of the target position of the substrate via the first optical arrangement, and a second optical arrangement arranged on a second side of the substrate, wherein the illumination unit may be configured to illuminate the target position of the substrate via the second optical arrangement. The second side may be opposite the first side. The substrate may be arranged/placed in an XY-plane. The first side of the substrate may be a first side/space/place with respect to the XY-plane. The second side of the substrate may be a second side/space/place with respect to the XY-plane, opposite to the first side/space/place. Thus, the first optical arrangement and the second optical arrangement may be arranged on opposite sides of the substrate/XY-plane. The substrate may be arranged in a holder such that the substrate may be accessible/reachable, e.g. for light, from both the first side and the second side. The first optical arrangement may be arranged between the substrate and the image capturing device. The second optical arrangement may be arranged between the substrate and the illumination unit. The first optical arrangement may comprise an objective lens/final lens and/or a field lens. The second optical arrangement may comprise an objective lens/final lens and/or a field lens. The first and second optical arrangements may comprise different types of objective lenses. In an example, the first optical arrangement may comprise an objective lens/final lens, and the second optical arrangement may comprise a field lens. Preferably, the first side of the substrate may be a side of the substrate having/provided with a layer/coating and/or a patterned layer/coating to be evaluated. The first optical arrangement may comprise an imaging part arranged to have an imaging optical path for directing light from the target position of the substrate to the image capturing device, such as light from the illumination unit. The first and/or the second optical arrangement may comprise an illumination part arranged to have an illumination optical path for directing/transmitting the illuminating light from the illumination unit to the target position of the substrate. Light from the illumination unit may be transmitted/provided to the target position of the substrate from the second side via the second optical arrangement and/or from the first side via the first optical arrangement.

By this, light from the illumination unit may be provided to the target position on/from one side of the substrate, and the at least one image of the target position may be captured on/from the other side of the substrate. The light may be at least partially transmitted through the substrate, for example in the light-transmissive parts of a patterned substrate.

The present embodiments makes it is possible to perform transmission measurements for evaluating the substrate and/or combine transmission measurements with reflection measurements for evaluating the substrate. The first optical arrangement and the second optical arrangement arranged on opposite sides of the substrate may provide an improved contrast in the at least one captured image may be provided. Furthermore, by being able to perform both transmission and reflection measurements, an improved versatility and flexibility of the evaluation of the substrate may be provided. For example, using both transmission measurements and reflection measurements may make it easier to distinguish any defects and/or any inaccuracies of the substrate from particles and/or dirt which may contaminate the substrate.

In an example embodiment of the present invention, there is provided a device for evaluating a substrate. The device may comprise the evaluation system according to an embodiment of the present invention and a platform and/or holder wherein the substrate is arranged on the platform and/or holder, wherein the at least one position sensor is configured to generate positional data indicating a position of the objective lens relative to at least one of the substrate and the platform. The platform may be configured to receive a substrate to be evaluated. The substrate may be arranged directly on the platform. The substrate may be arranged indirectly on the platform, e.g. on an air cushion. The platform may be configured to move relative to the at least one optical arrangement and/or the image capturing device of the evaluation system. The at least one optical arrangement and/or the image capturing device of the evaluation system may be configured to move relative to the platform and thereby the substrate arranged on the platform.

In a second aspect of the inventive concept, there is provided a method for evaluating a substrate using an evaluation system comprising at least one optical arrangement, an image capturing device, an illumination unit and a control unit. The method comprises performing an imaging sequence which comprises the step of sending, from the control unit to the image capturing device, at least one image trigger signal, and sending, from the control unit to the illumination unit, at least one illumination trigger signal. The method further comprises capturing, by the image capturing device, an image of a target position of the substrate, via the at least one optical arrangement, based on the at least one image trigger signal, and illuminating, by the illumination unit, the target position of the substrate, via the at least one optical arrangement, based on the at least one illumination trigger signal.

Further objectives of, features of, and advantages with the present invention will become apparent when studying the following detailed disclosure, the drawings, and the appended claims. Those skilled in the art realize that different features of the present invention, even if recited in different claims, can be combined in embodiments other than those described in the following.

### BRIEF DESCRIPTION OF THE DRAWINGS

This and other aspects of the present invention will now be described in more detail, with reference to the appended drawings showing embodiment(s) of the invention.
Figs. 1A-1C schematically illustrate examples of a substrate to be evaluated.
Fig. 2 schematically illustrates an evaluation system for evaluating a substrate according to a first aspect of the invention.
Fig. 3 schematically illustrates a device and system for evaluating a substrate according to some embodiments of the invention.
Fig. 4 schematically illustrates a device and system for evaluating a substrate according to some embodiments of the invention.
Fig. 5 schematically illustrates an evaluation system for evaluating a substrate according to some embodiments of the invention.
Figs. 6A-6F schematically illustrates examples of imaging sequences.
Fig. 7 schematically illustrates a diagram showing an example operation according to some embodiments of the invention.
Fig. 8 schematically illustrates a method for evaluating a substrate according to a second aspect of the invention.

### DETAILED DESCRIPTION

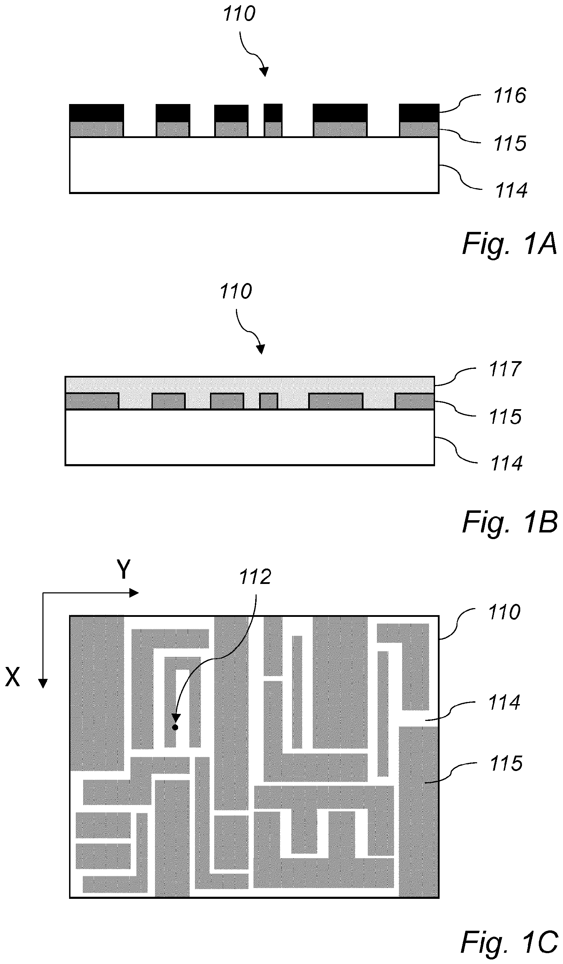

With reference to Figs. 1A-1C, schematic illustrations of examples of a substrate 110 are shown. In Figs. 1A-1B, example substrates are schematically illustrated in cross-section and in Fig. 1C an example substrate is schematically illustrated from above. In Figs. 1A-1C, the substrate 110 comprises a plate 114 and a first layer 115. The plate may be a flat plate. The first layer 115 may be patterned as illustrated in Figs. 1A-1C. The first layer 115 is provided on a surface of the plate 114. In Fig. 1A, the substrate further comprises a second layer 116. The second layer 116 may be patterned, i.e. comprise a pattern, as shown in Fig. 1A. The second layer 116 is arranged on the first layer 115, e.g. on a surface of first layer 115. In Fig 1B, the substrate further comprises a third layer 117. The third layer 117 is arranged on the first layer 115, and may also be arranged on the plate 114. The substrate 110 may only comprise a plate 114 and a first layer 115. It is to be understood that the different layers may fully or at least partially cover/enclose a surface of at least one of the first plate 110, the first layer 115 and the second layer 116.

The plate 114 may comprise a hard and/or temperature-stable material. The plate 114 may comprise a light-transmissive material, i.e. be transparent. The plate 114 may comprise a material based on the chemical compound silica, such as, glass, Quartz or Soda-lime glass. The first layer 115 may comprise an opaque material. The first layer 115 may comprise a metal-based material, such as chromium. The second layer 116 may comprise a resist. The third layer 117 may comprise a pellicle. The third layer 117 may be a thin membrane that partially or fully covers the first layer 115 and/or the plate 114. The third layer 117 may comprise a light-transmissive material, i.e. be transparent. The third layer 117 may be configured to prevent the substrate 110 from being contaminated. In other words, the third layer 117 may comprise a protective surface configured to protect at least one of the plate 114, the first layer 115 and the second layer 116.

In an example, the substrate 110 may comprise a glass plate 114, i.e. the plate 114 may be a glass plate, and an opaque patterned layer of chromium 115. The substrate 110 may be a photo mask.

In Fig. 1C, an example substrate is illustrated from above and arranged in an XY-plane. The XY-plane has a X-direction and an Y-direction orthogonal to each other. In Fig 1C, the substrate comprises a plate 114 and a first layer 115. The plate 114 is illustrated as white areas and the first layer 115 is illustrated as grey areas in the figure. The plate 114 may be light-transmissive and the first layer 115 may represent opaque areas. In Fig. 1C, a target position 112 on the substrate 110 is illustrated. The target position 112 may be defined by XY-coordinates in the XY-plane.

In an example, the evaluation system according to the present invention may evaluate a substrate 110 by measuring the placement or marking of a pattern of the substrate 110. The first layer 115 and/or the second layer 116 may form the pattern of the substrate 110. In other words, the evaluation system may be configured to determine a pattern of the substrate, such as a pattern formed by the first layer 115 and/or the second layer 116, wherein the first layer 115 and/or the second layer 116 are arranged on the plate 114. Determining the pattern may mean determining a shape and/or a size of at least a part of the substrate, e.g. the first layer 115 and/or the second layer. Determining a shape and/or size may comprise determining a measurement such as a distance and/or length of one or more features of the substrate. The pattern may be a predetermined pattern. Thus, the evaluation system may be configured to detect defects in the pattern by comparing with a predetermined pattern, i.e. a desired pattern. A control unit (not shown) may be configured to determine the pattern. A predetermined set of target positions may be selected to be evaluated thereby evaluating the pattern at different positions on the substrate 110.

In an example, a substrate 110 may be inspected/evaluated by inspecting/evaluating defects or contamination of the substrate 110. For example, a substrate 110 comprising a third layer 117 may be inspected by examining if the surface of the layer 117 is contaminated, e.g. by particles. A predetermined set of target positions may be selected to be inspected thereby inspecting at different positions of the substrate 110.

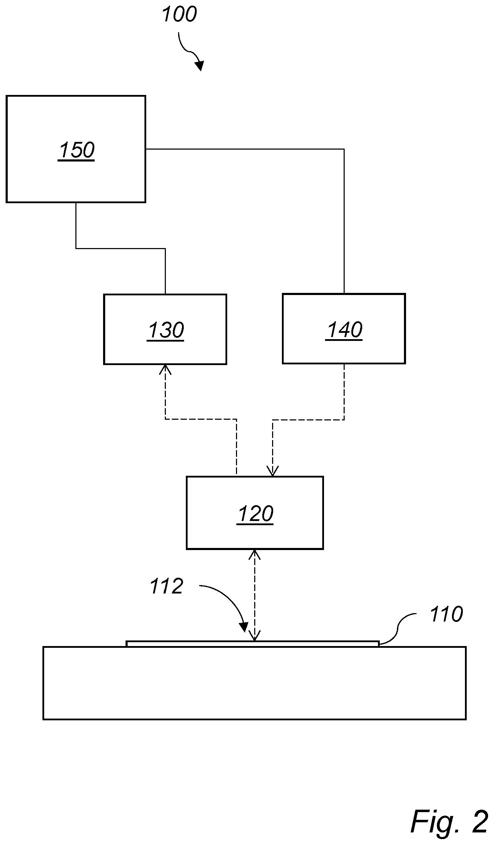

With reference to Fig. 2, a schematic illustration of an evaluation system 100 for evaluating a substrate 110 according to a first aspect of the invention is shown. The evaluation system 100 comprises an optical arrangement 120. The optical arrangement 120 is configured to have a focal point at a target position 112 on the substrate 110. The evaluation system 100 comprises an image capturing device 130. The image capturing device 130 is configured to capture at least one image of the target position 112 on the substrate 110 via the optical arrangement 120, meaning that the at least one image of the target position 112 is captured through the optical arrangement 120. The evaluation system 100 comprises an illumination unit 140. The illumination unit 140 is configured to illumination the target position 112 on the substrate 110 via the optical arrangement 120, meaning that the illumination is guided through the optical arrangement 120 to the target position 112. The optical arrangement 120 is arranged between the substrate 110 and the image capturing device 130 as well as the illumination unit 140, in the optical path, i.e. photons emanated from substrate 110 passes the optical arrangement 120 before reaching the image capturing device 130 and photons emanating from the illumination unit 140 passes the optical arrangement 120 before reaching the substrate 110.

In Fig. 2, the dashed lines and arrows illustrate the optical paths for illumination and image capturing. As seen in Fig. 2, the illumination, such as emitted light, from the illumination unit 140 is directed/transmitted through the optical arrangement 120 to the target position 112 on the substrate 110. The optical arrangement 120 may comprise an illumination part having an illumination optical path for directing/transmitting the emitted light from the illumination unit 140 to the target position 112. As also illustrated by dashed lines and arrows in Fig. 2, an image of the target position 112 on the substrate 110 is captured through the optical arrangement 120 by the image capturing device 130. The optical arrangement 120 may comprise an imaging part having an imaging optical path for directing light from the target position 112 to the image capturing device 130.

The evaluation system 100 comprises a control unit 150. The control unit 150 is connected to the image capturing device 130 and the illumination unit 140, respectively. The control unit 150 is configured to perform an imaging sequence, wherein the imaging sequence comprises at least one image trigger signal and at least one illumination trigger signal. The control unit 150 is configured to send the at least one image trigger signal to the image capturing device 130 and the at least one illumination trigger signal to the illumination unit 140. If the image capturing device 130 receives an image trigger signal, then the image capturing device 130 is configured to capture an image of the target position 112 on the substrate 110. If the illumination unit 140 receives an illumination trigger signal, then the illumination unit 140 is configured to illuminate the target position 112 on the substrate 110.

The evaluation system 100 may be configured to evaluate a substrate 110 based on the at least one image. For example, the control unit 150 or a second control unit (not shown) may be configured to determine at least one of a parameter and a condition of the substrate 110. The parameter may be an evaluation metric based on the at least one image. The evaluation metric may indicate a status, condition and/or shape of the substrate 110 and/or a pattern on the substrate 110.

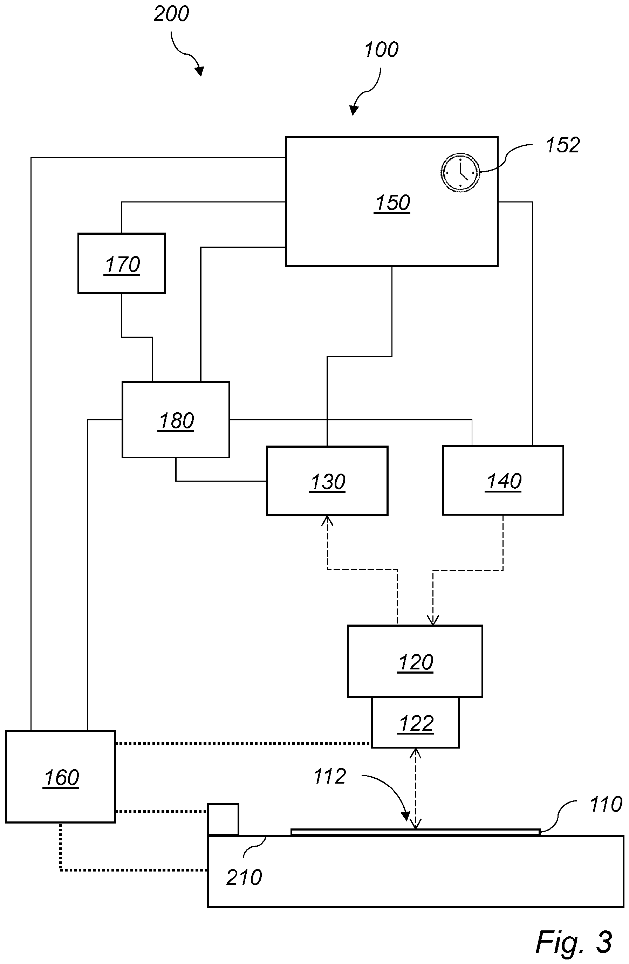

With reference to Fig. 3, a schematic illustration of a device 200 and system 100 for evaluating a substrate 110 according to some embodiments is shown. The device 200 comprises an evaluation system 100 according to some embodiments and a platform 210. The platform 210 is illustrated as a solid object/plate. The evaluation system 100 in Fig. 3 is adapted for reflection measurement for evaluating the substrate, the platform 210 may be opaque.
If the evaluation system 100 would be adapted to suit both reflection measurements and transmission measurements, the platform 210 may comprise a light-transmissive material. The platform 210 may in some embodiments comprise a holder. The substrate 110 is arranged on the platform 210. The platform 210 may be configured to move relative to the optical arrangement 120 and/or the image capturing device 130 of the evaluation system 100. The optical arrangement 120 and/or the image capturing device 130 of the evaluation system 100 may be configured to move relative to the platform 210 and thereby the substrate 110 arranged on the platform 210. It should be noted that the evaluation system 100 of the device 200 illustrated in Fig. 3 has several features in common with the evaluation system 100 shown in Fig. 2. It is hereby referred to Fig. 2 and the associated text for an increased understanding of these features of the evaluation system 100.

As illustrated in Fig. 3, the evaluation system 100 comprises an optical arrangement 120 which comprises an objective lens 122. The objective lens 122 is the optical component comprised in the optical arrangement 120 being closest to the substrate 110. The objective lens 122 is configured to focus light on/from the target position 112 on the substrate 110, which is illustrated with dashed arrows between the objective lens 122 and the substrate 110 in Fig. 3. As also seen in Fig. 3, the evaluation system 100 comprises at least one position sensor 160. The position sensor 160 is configured to generate positional data indicating a position of the objective lens 122 relative to the substrate 112. The position sensor 160 may be configured to measure positions of and/or distances to the objective lens 122 and/or the substrate 110, thereby indicating a position of the objective lens 122 relative to the substrate 110. For example, as illustrated with dotted lines in Fig. 3, the position sensor 160 may be configured to generate positional data indicating a position of the objective lens 122 relative to the substrate 112 by measuring the position of or distance to the objective lens 122 and the position of or distance to the platform 210 where the substrate 110 may be arranged. The position sensor 160 is connected to the control unit 150. The control unit 150 is configured to receive the positional data from the at least one position sensor 160 and perform an imaging sequence based on the positional data. For example, the positional data may indicate a certain position of the objective lens 122 relative to the substrate 110 corresponding to a target position 112 on the substrate 110 to be evaluated. Then the control unit 150 may perform a imaging sequence at that target position 112. The evaluation system 100 may be configured to evaluate a substrate 110 based on at least a part of the positional data. For example, the control unit 150, may be configured to determine a parameter and/or a condition of the substrate 110, such as an evaluation metric, based on the at least one image and at least part of the positional data.

As seen in Fig. 3, the control unit 150 may comprise a timer 152, and be configured to run the timer 152. The timer 152 may be configured to produce pulses/signals/prompts/indications at regular intervals in time. The timer 152 may be synchronized with the position sensor 160 and the performance/execution of an imaging sequence. For example, the position sensor 160 may indicate a position on the substrate 110 to be evaluated whereas the control unit 150 may be configured to run the timer 152 and thereby perform an imaging sequence based on the timer 152.

The evaluation system 100 comprises a secondary sensor 170, as shown in Fig. 3. The secondary sensor 170 may be a pneumatic sensor, an optical sensor, an inductive sensor, an accelerometer or a temperature sensor. The secondary sensor 170 may generate sensor data based on performed measurements. At least one secondary sensor 170 may be connected to/perform measurements of at least one of the optical arrangement 120, the image capturing device 130, the illumination unit 140, the position sensor 160 and the platform 210 where the substrate 110 may be arranged/placed. As an example, a secondary sensor 170 may be an inductive sensor connected to the platform 210 to measure the position of the platform 210. As another example, a secondary sensor 170 may be an optical sensor connected to the optical arrangement 120 to measure the distance from the objective lens 122 to the substrate 110.

The evaluation system 100 may be configured to evaluate a substrate 110 based on at least part of the sensor data. For example, the control unit 150 may be configured to determine a parameter and/or a condition, such as an evaluation metric, of the substrate 110 based on the at least one image, at least part of the positional data and at least part of the sensor data. By combining the sensor data with positional data from the position sensor 160 and images captured by the image capturing device 130, the accuracy and fidelity of the evaluation system 100 may be improved. For example, the secondary sensor 170 may comprise a temperature sensor configured to measure thermal disturbances/changes in the evaluation system 100, e.g. in one or more components of the evaluation system 100. Thus, if the control unit 150 performs an imaging sequence, the sensor data from the temperature sensor 170 that the control unit 150 receives during the imaging sequence may be combined and synchronized in time with the captured images and the positional data.

In an example, the evaluation system 100 comprises a second control unit (not shown) configured to determine a parameter and/or a condition of the substrate 110, such as an evaluation metric, based on at least one of the at least one image, the positional data and the sensor data. The second control unit may be arranged externally to the evaluation system 100, but still be connected wirelessly or via a cable/wire.

The evaluation system 100 comprises a data storage 180. The data storage 180 is configured to store evaluation data. The evaluation data comprises at least one of the at least one image, the positional data, the sensor data, and log data of the at least one image trigger signal and the at least one illumination trigger signal. The data storage 180 may be connected to at least one of the control unit 150, the image capturing device 130, the illumination unit 140, the position sensor 160 and the secondary sensor 170. In other words, the data storage 180 may receive data from components of the evaluation system and store it, e.g. for further processing. The data storage 180 may be connected to the second control unit (not shown). As the evaluation data may be stored in the data storage 180, reference between the different data sets in the evaluation data may be made to create a data log. A data set may be, e.g., positional data generated by the at least one position sensor 160, sensor data generated by a secondary sensor 170 or at least one image captured by the image capturing device 130 during an imaging sequence or an evaluation run performed by the evaluation system. For example, the positional data may comprise a reference to the at least one image, such that the positional data may be associated with the at least one image. In another example, the sensor data may comprise a first reference to the at least one image. Further, the sensor data may comprise a second reference to positional data, generated by the at least one position sensor, related to the at least one image. In other words, the sensor data may comprise a reference to at least one of the positional data and the at least one image. A reference may be made between a data set in the evaluation data and time generated by a timing unit. The timing unit may be a timer 152.

The evaluation system 100 may be configured to generate at least one processed image based on at least one of the evaluation data, the parameter and the condition. Furthermore, the evaluation system 100 may be configured to generate a processed image based on a plurality of images captured by the image capturing device 130. For example, the evaluation system 100 may be configured to generate the processed image by taking an average, and/or by weighted averaging, of a plurality of images, possibly in combination with the parameter and/or condition of the substrate 110. The control unit 150 may be configured to generate the at least one processed image. The evaluation system 100 may be configured to determine the parameter and/or the condition of the substrate 110 based on a processed image.

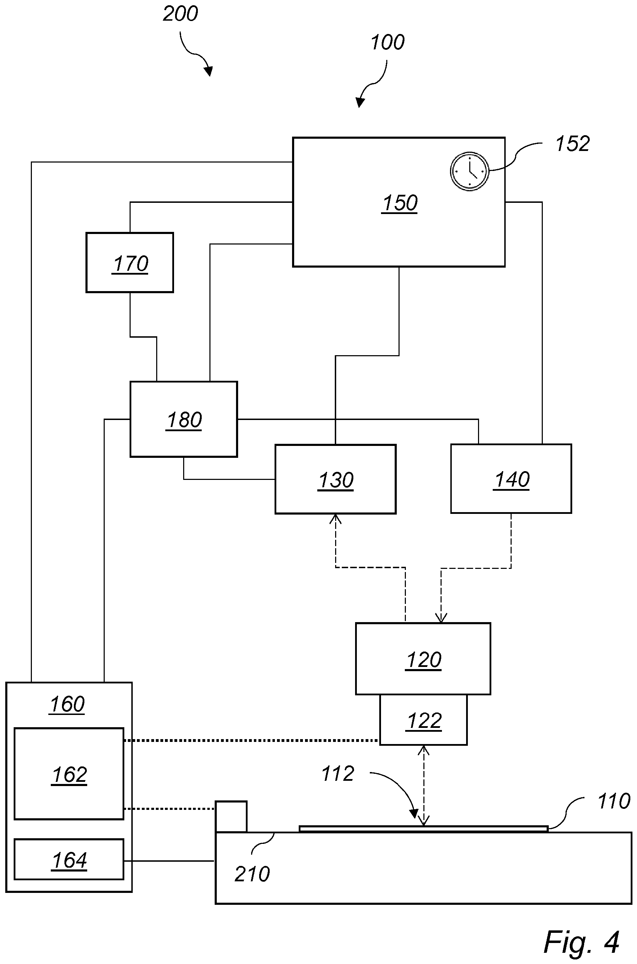

With reference to Fig. 4, a schematic illustration of a device 200 for evaluating a substrate 110 according to some embodiments is shown. The device 200 comprises an evaluation system 100 according to some embodiments and a platform 210. The substrate 110 is arranged on the platform 210. The platform 210 may be configured to move relative to the optical arrangement 120 and/or the image capturing device 130 of the evaluation system 100. The optical arrangement 120 and/or the image capturing device 130 of the evaluation system 100 may be configured to move relative to the platform 210 and thereby the substrate 110 arranged on the platform 210. It should be noted that the evaluation system 100 of the device 200 illustrated in Fig. 4 has several features in common with the evaluation system 100 of device 200 shown in Fig. 3 and the evaluation system 100 shown in Fig. 2. It is hereby referred to Fig. 2 and Fig. 3 and the associated text for an increased understanding of these features of the evaluation system 100.

As illustrated in Fig. 4, the evaluation system 100 comprises an interferometer 162 and an encoder 164. The interferometer 162 is configured to measure/determine a position of the objective lens 122 relative to the substrate 110. This may be done by measuring/determining a position of or distance to the objective lens 122 and a position of or distance to the substrate 110, or the platform 210 which the substrate 110 is arranged on. This is illustrated in Fig. 4 by dotted lines from the interferometer 162 to the objective lens 122 and to a part indicating the position of the platform 210. The encoder 164 is configured to measure a mechanical position, such as a distance from a point of origin. The encoder 164 is connected to the platform 210. The encoder 164 may measure/determine the mechanical position of the substrate 110 or the platform 210 on which the substrate 110 is arranged. The interferometer 162 and the encoder 164 is connected to the control unit 150, and possibly also the data storage 180. The control unit 150 is connected to the data storage 180 and may be configured to send evaluation data to the data storage 180. The positional data generated by the interferometer 162 and/or the encoder 162 may be stored/logged in the data storage 180.

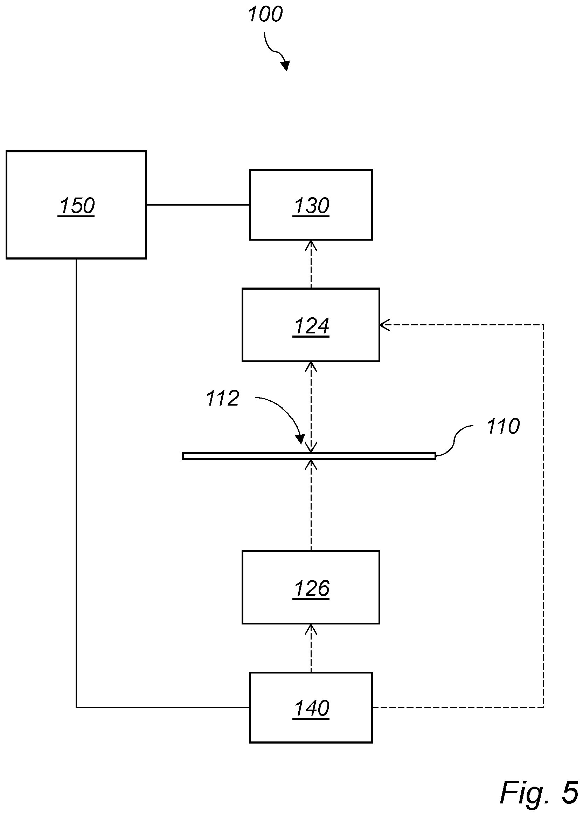

With reference to Fig. 5, a schematic illustration of an evaluation system 100 according to some embodiments is shown. It should be noted that the evaluation system 100 illustrated in Fig. 5 has several features in common with the evaluation system 100 shown in Fig. 2 and the evaluation system 100 of device 200 shown in Figs. 3-4. It is hereby referred to Figs. 2-4 and the associated text for an increased understanding of these features of the evaluation system 100. In Fig. 5, the substrate 110 may be arranged in a holder or arranged on a platform. The substrate 110 may be arranged in the holder/on the platform such that both sides (upper side and lower side in the figure) of the substrate 110 are accessible/visible. In Fig. 5, the evaluation system 100 comprises a first optical arrangement 124 and a second optical arrangement 126. The first optical arrangement 124 is arranged between the substrate 110 and the image capturing device 130. The first optical arrangement 124 is arranged on a first side of the substrate 110 which in the figure is illustrated as the upper/top side of the substrate 110. Thereby the first optical arrangement 124 is arranged above the substrate 110 in the figure. The second optical arrangement 126 is arranged between the substrate 110 and the illumination unit 140. The second optical arrangement 126 is arranged on a second side of the substrate 110 which in the figure is illustrated as the under/lower side of the substrate 110. Thereby the second optical arrangement 126 is arranged below the substrate 110 in the figure. The image capturing device 130 captures the at least one image of the target position 112 via/through the first optical arrangement 124. The illumination unit 140 illuminates the target position 112 via/through the second optical arrangement 126.

In Fig. 5, the dashed lines and arrows illustrate the optical paths for illumination and image capturing. As seen in Fig. 5, the illumination, such as emitted light, from the illumination unit 140 is directed/transmitted through the second optical arrangement 126 to the target position 112 on the substrate 110. The target position 112 is thereby be illuminated from below in the figure. The second optical arrangement 126 may comprise an illumination part having an illumination optical path for directing/transmitting the emitted light from the illumination unit 140 to the target position 112. As also illustrated by dashed lines and arrows in Fig. 5, an image of the target position 112 of the substrate 110 is captured through the first optical arrangement 124 by the image capturing device 130. The first optical arrangement 124 may comprise an imaging part having an imaging optical path for directing light from the target position 112 to the image capturing device 130. By having this arrangement, the evaluation system 100 in Fig. 5 is suitable for transmission measurements for evaluating the substrate 110.

In an example, the illumination/emitted light from the illumination unit 140 may also be directed/transmitted through the first optical arrangement 124 to the target position 112 on the substrate 110. This is also illustrated in the figure as a dashed arrow from the illumination unit 140 to the optical arrangement 124. Thereby the target position 112 may be illuminated from above in the figure. By this, reflection measurements for evaluating the substrate 110 may also be performed by the evaluation system 100. Therefore, the example of evaluation system 100 illustrated in Fig. 5 is suitable for transmission measurements and/or reflection measurements for evaluating the substrate. At least one image may be captured with transmissions measurements, i.e. that the substrate 110 is illuminated from one side and the at least one image is captured on the other side. At least one image may be captured with reflection measurements, i.e. that the substrate 110 is illuminated from the same side as the image is captured from. Images captured using transmission measurements and reflection measurements may be combined for evaluating a substrate, e.g. by the control unit 150 and/or a second control unit. By this, the evaluation may be improved, for example, it may be easier to distinguish between defects of the substrate and dirt/dust contaminating the substrate.

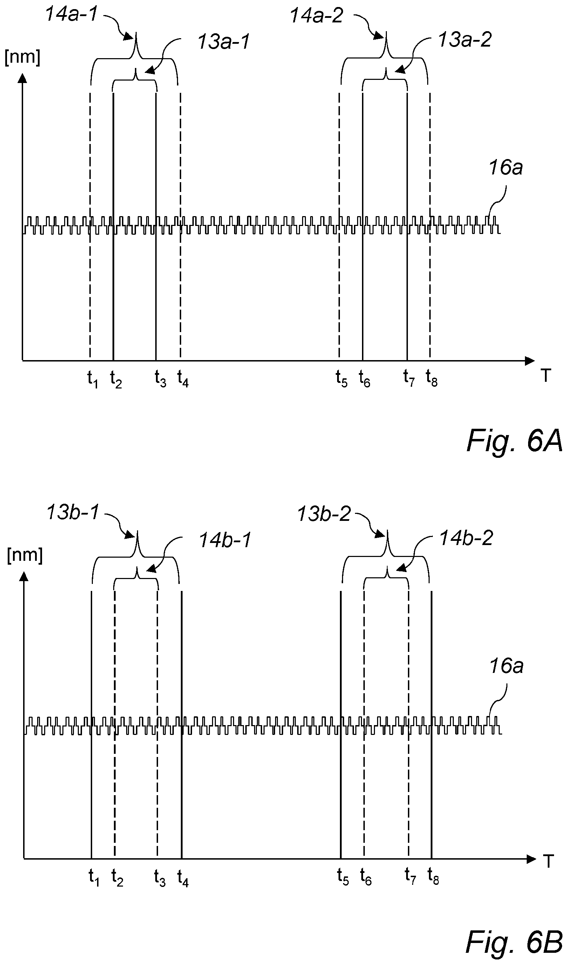

With reference to Figs. 6A-6F, examples of imaging sequences that may be performed by the control unit 150 are shown. In Figs. 6A-6F, positional data 16a, 16c-1, 16c-2, 16e and 16f are illustrated as functions of time, T. A position of the substrate relative the image capturing device and/or the optical arrangement, is shown on the vertical axis, in nanometer [nm], and the time, T, is shown on the horizontal axis. The positional data 16a, 16c-1, 16c-2, 16e and 16f may comprise data on a position in a direction parallel with an X-axis, and/or on a position in a direction parallel with a Y-axis, and/or on a position in a direction parallel with an Z-axis, wherein the Y-axis is perpendicular to the X-axis, and wherein the Z-axis is perpendicular to the X-axis and the Y-axis respectively. In the case when the positional data comprises data of the Z-axis, the positional data regarding the position along the Z-axis may be determined by e.g. a pneumatic sensor and/or optical sensor. In other words, the at least one position sensor may comprise at least one of a pneumatic sensor and/or optical sensor configured to generate positional data indicating a position along a Z-axis of the substrate relative the objective lens.

The time, T, may be set by a clock/timing unit. The timing unit may be a timer comprised in a control unit of the evaluation system. An imaging sequence may be performed based on the timer, and thereby the image capturing and the illumination may be performed based on time, T. The timer and the positional data 16a, 16c-1, 16c-2, 16e and 16f may be synchronized.

A window signal in the imaging sequence may be defined over an interval of time. The window signal may be considered a signal with zero-value outside a chosen interval, e.g. the interval of time it is defined over. The window signal may be symmetric, e.g. symmetric in amplitude over time. The window signals may be set/adjusted/configured to capture fluctuations in the positional data, which may then be accounted for when evaluating the substrate. For example, the window signal may be configured to capture fluctuation patterns, e.g. in the form of at least partially periodic fluctuations in one or more dimensions, such as X- and Y-direction. A control unit of the evaluation system may thus be configured to determine a first position of the substrate based on positional data from the time intervals corresponding to the image window signal and/or the illumination window signal. The control unit may further be configured to determine deviations in the positional data from the time intervals corresponding to the at least one image window signal and/or the at least one illumination window signal, such as periodic fluctuations, and determine the first position based on the determined deviations.

In Fig. 6A, the imaging sequence comprises a first and a second image window signal, 13a-1, 13a-2, and a first and a second illumination window signal, 14a-1, 14a-2. Positional data 16a is illustrated in Fig. 6A. The positional data 16a may be generated by a position sensor comprised in the evaluation system. In the figure the positional data 16a may illustrate the position of a substrate relative to the optical arrangement and/or the image capturing device in one of the X-dimension, the Y-dimension or the Z-dimension. The position of the substrate relative the image capturing device and/or the optical arrangement, indicated by the positional data 16a, is kept as still as possible during image capturing, but there are still small fluctuations in position which is illustrated with the varying peaks of positional data 16a. For example, in Fig. 6A, the positional data 16a may indicate the position of the substrate in the X-dimension, meaning that the substrate is kept as still as possible in the X-direction. The substrate may also be kept as still as possible in the Y-dimension and the Z-dimension. Then the imaging sequence may be performed while the substrate is kept as static as possible in the three dimensions. The positional data 16a may correspond to a target position, i.e. a position on the substrate that is desired to be evaluated.

In Fig. 6A, the first and second image window signals, 13a-1, 13a-2, are defined over an interval in time, T, illustrated as solid lines. The first image window signal 13a-1 is defined in the time interval t₂ to t₃, meaning that the first image window signal 13a-1 starts at time t₂ and ends at time t₃. The second image window signal 13a-2 is defined in the time interval t₆ to t₇, meaning that the second image window signal 13a-2 starts at time t₆ and ends at time t₇. The first and second illumination window signals 14a-1, 14a-2, are defined over an interval in time, T, illustrated as dashed lines. The first illumination window signal 14a-1 is defined in the time interval t₁ to t₄, meaning that the first illumination window signal 14a-1 starts at time t₁ and ends at time t₄. The second illumination window signal 14a-2 is defined in the time interval t₅ to t₈, meaning that the second illumination window signal 14a-2 starts at time t₅ and ends at time t₈. As seen in Fig. 6A, the first illumination window signal 14a-1 completely overlaps the first image window signal 13a-1, since t₁ < t₂ < t₃ < t₄. The same holds for the second image window signal 13a-2 and the second illumination window signal 14a-2, wherein the second illumination window signal 14a-2 completely overlaps the second image window signal 13a-2 since t₅ < t₆ < t₇ < t₈.

In Fig. 6B, positional data 16a is illustrated. Positional data 16a is described above in relation to Fig. 6A, and the same applies to Fig. 6B. Furthermore, in Fig. 6B, the imaging sequence comprises a first and a second image window signal, 13b-1, 13b-2, (solid lines), and a first and a second illumination window signal, 14b-1, 14b-2, (dashed lines), each defined over an interval in time, T. In Fig. 6B the first image window signal 13b-1 is defined in the time interval t₁ to t₄, meaning that the first image window signal 13b-1 starts at time t₁ and ends at time t₄. The second image window signal 13b-2 is defined in the time interval t₅ to t₈, meaning that the second image window signal 13b-2 starts at time t₅ and ends at time t₈. The first illumination window signal 14b-1 is defined in the time interval t₂ to t₃, meaning that the first illumination window signal 14b-1 starts at time t₂ and ends at time t₃. The second illumination window signal 14b-2 is defined in the time interval t₆ to t₇, meaning that the second illumination window signal 14b-2 starts at time t₆ and ends at time t₇. As seen in Fig. 6B, the first image window signal 13b-1 completely overlaps the first illumination signal 14b-1 , since t₁ < t₂ < t₃ < t₄. The same holds for the second image window signal 13b-2 and the second illumination window signal 14b-2, wherein the second image window signal 13b-2 completely overlaps the second illumination window signal 14b-2 since t₅ < t₆ < t₇ < t₈.

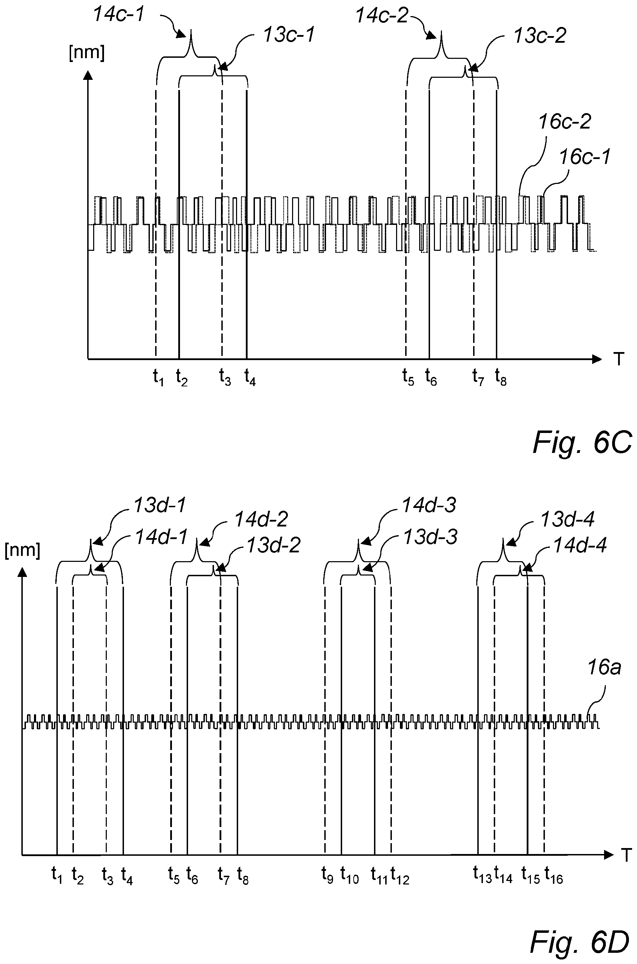

In Fig. 6C, positional data 16c-1 and positional data 16c-2 are illustrated. As an example, the positional data 16c-1 and 16c-2 in Fig. 6C may illustrate positional data in two dimensions generated by a position sensor comprised in the evaluation system. For example, the positional data 16c-1 may illustrate the position of the substrate relative the optical arrangement and/or the image capturing device in the X-dimension and the positional data 16c-2 may illustrate the position of the substrate relative the optical arrangement and/or the image capturing device in the Y-dimension. As described above, the position of the substrate relative the image capturing device and/or the optical arrangement is kept as still as possible during image capturing, but there are still small fluctuations in position which is illustrated with the varying peaks of positional data 16c-1 and 16c-2 respectively. For example, the imaging sequence in Fig. 6C is performed while the substrate is kept as still/static as possible along the X-axis and the Y-axis. The positional data 16c-1 and 16c-2 may correspond to a target position, i.e. a position on the substrate that is desired to be evaluated. The evaluation system may be configured to evaluate the substrate based also on the fluctuations in position. The fluctuations in position may be logged in a data storage, and used to evaluate the substrate.

Furthermore, in Fig. 6C, the imaging sequence comprises a first and a second image window signal, 13c-1, 13c-2, (solid lines) and a first and a second illumination window signal, 14c-1, 14c-2, (dashed lines). In Fig. 6C, the first image window signal 13c-1 is defined in the time interval t₂ to t₄, meaning that the first image window signal 13c-1 starts at time t₂ and ends at time t₄. The second image window signal 13c-2 is defined in the time interval t₆ to t₈, meaning that the second image window signal 13c-2 starts at time t₆ and ends at time t₈. The first illumination window signal 14c-1 is defined in the time interval t₁ to t₃, meaning that the first illumination window signal 14c-1 starts at time t₁ and ends at time t₃. The second illumination window signal 14c-2 is defined in the time interval t₅ to t₇, meaning that the second illumination window signal 14c-2 starts at time t₅ and ends at time t₇. As seen in Fig. 6C, the first image window signal 13c-1 and the first illumination window signal 14c-1 are partially overlapped, since t₁ < t₂ < t₃ < t₄. The same holds for the second image window signal 13c-2 and the second illumination window signal 14c-2, wherein the second image window signal 13c-2 partially overlaps the second illumination window signal 14c-2 since t₅ < t₆ < t₇ < t₈.

In Fig. 6D, positional data 16a is illustrated. Positional data 16a is described above in relation to Fig. 6A, and the same applies to Fig. 6D. Furthermore, in Fig. 6D, the imaging sequence comprises a first, a second, a third and a fourth image window signal, 13d-1, 13d-2, 13d-3, 13d-4, (solid lines) and a first, a second, a third and a fourth illumination window signal, 14d-1, 14d-2, 14d-3, 14d-4, (dashed lines). In Fig. 6D it is illustrated that an imaging sequence may comprise multiple image window signals and multiple illumination window signals, defined during time intervals of different length and at different points in time. For example, the first image window signal 13d-1 completely overlaps the first illumination window signal 14d-1, and the fourth image window signal 13d-4 and the fourth illumination window signal 14d-4 partially overlap each other. As seen in Fig. 6D, the image window signals and the illumination window signals in an imaging sequence may overlap each other in different manners. The imaging sequence may be customized depending on the evaluation of a substrate to be carried out.

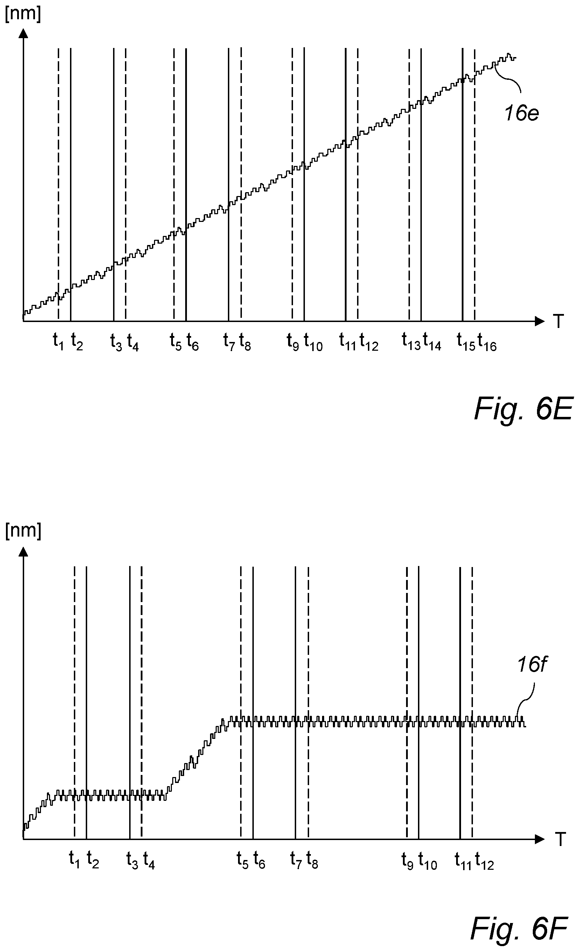

In Fig. 6E, positional data 16e and an imaging sequence are illustrated. The positional data 16e may be generated by a position sensor comprised in the evaluation system. The positional data 16e in the figure illustrates that the position of the substrate relative the image capturing device and/or the optical arrangement in one of the X-dimension, the Y-dimension or Z-direction is changing over time, T. Thereby, the imaging sequence in Fig. 6E is performed during movement of the substrate relative the image capturing device and/or the optical arrangement in one of the dimensions. The position of the substrate relative the image capturing device and/or the optical arrangement, indicated by the positional data 16e, is changing during image capturing, but there are still small fluctuations in position which is illustrated with the varying peaks of positional data 16e. For example, if the position of the substrate relative the image capturing device and/or the optical arrangement is changing in the X-dimension, then the substrate is moving relative the image capturing device and/or the optical arrangement along the X-axis. Then, the imaging sequence and the image capturing is performed during this relative movement in the X-dimension. The evaluation system, or a control unit of the evaluation system, may be configured to receive a position sequence comprising a set of target positions. The position sequence may describe a movement of the substrate relative the image capturing device and/or the optical arrangement in one or more dimensions. For example, a target position may comprise an XY-coordinate corresponding to a position on the substrate. The movement of the substrate relative the image capturing device and/or the optical arrangement may thus be along an X-axis and/or along a Y-axis. The evaluation system, or the control unit, may be configured to move the focus of the optical arrangement between one or more target positions in the position sequence. For example, the evaluation system, or the control unit, may be configured to move the focus from a first target position to a second position, and so forth, i.e. iterating over the set of target positions. It is to be understood that the movement of the focus is the movement of the optical arrangement relative the substrate. Hence, in some embodiments a platform, upon which the substrate is arranged, may be moved, and in some embodiments the optical arrangement, or the objective lens comprised in the optical arrangement, is moved. In some embodiments, the evaluation system or the control unit may order an external control unit outside of the evaluation system to control the movement of the focus.

In an example, the movement of the focus may be in the X-direction, i.e. along the X-axis. Then the value of the X-coordinate may change between a first target position and a second target position in the position sequence. By receiving the position sequence, the control unit may control the movement of the substrate relative the image capturing device and/or the optical arrangement along the X-axis. The movement of the focus may be synchronized with time, T. In Fig. 6E, the vertical axis may show the position of the substrate relative the image capturing device and/or the optical arrangement along the X-axis, For example, the position of the substrate relative the image capturing device and/or the optical arrangement along the X-axis may change with a velocity in the order of 1 pm/s. The imaging sequence is performed during this movement as seen in Fig. 6E. The evaluation system may be configured to generate a processed image based on a plurality of images taken during movement, such as the one illustrated in Fig. 6E.

In Fig. 6F, positional data 16f and an imaging sequence are illustrated. The positional data 16f may be generated by a position sensor comprised in the evaluation system. The positional data 16f in the figure illustrates that the position of the substrate relative the image capturing device and/or the optical arrangement in one of the X-dimension, the Y-dimension or Z-dimension is partly changing over time, T, and partly static/kept as still as possible over time, T. Fig. 6F illustrates that during an imaging sequence, changing the position of the substrate relative the image capturing device and/or the optical arrangement and keeping the position as still as possible may be combined. The evaluation system, or a control unit of the evaluation system, may as described above with respect to Fig. 6E, be configured to receive a position sequence comprising a set of target positions. The control unit may be configured to run a timer based on the position sequence, for example, the control unit may be configured to initiate the timer at certain positions. If, for example, the positional data 16f indicates a target position in the position sequence, the control unit may be configured to initiate/run the timer and perform an imaging sequence and/or send at least one image trigger signal and at least one illumination trigger signal based on the timer at that indicated target position. As seen in Fig. 6F, the position of the substrate relative the optical arrangement and/or the image capturing device, is kept as still as possible during two time intervals, and is changed between them. For example, the positional data 16f may indicate a first target position in the position sequence. Then the control unit may be configured to send at least one image trigger signal and at least one illumination trigger signal. As shown in Fig. 6F, a first image trigger signal comprises a first image window signal defined in the time interval t₂ to t₃, and a first illumination trigger signal comprises a first illumination window signal defined in the time interval t₁ to t₄. The positional data 16f may then indicate a second target position in the position sequence. Then the control unit may be configured to send at least one image trigger signal and at least one illumination trigger signal. As shown in Fig. 6F, a second image trigger signal comprises a second image window signal defined in the time interval t₆ to t₇, and a second illumination trigger signal comprises a second illumination window signal defined in the time interval t₅ to t₈. At the second target position, a third image trigger signal and a third illumination trigger signal is sent by the control unit. As seen in Fig. 6F, the third image trigger signal comprises a third image window signal defined in the time interval t₁₀ to t₁₁, and the third illumination trigger signal comprises a third illumination window signal defined in the time interval t₉ to t₁₂. Thus, different types of imaging sequences may be performed at different target positions in the position sequence.

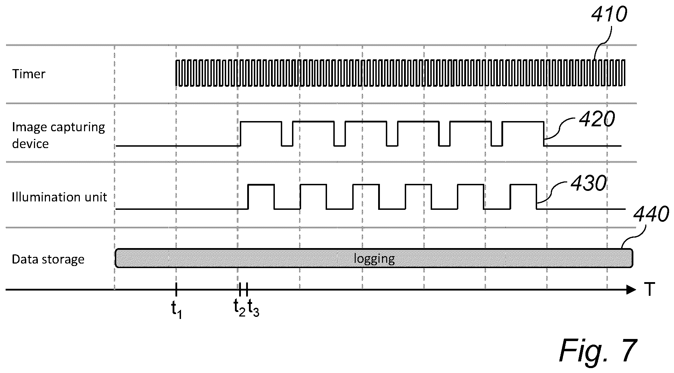

With reference to Fig. 7, a schematic diagram illustrating an example operation of the evaluation system according to some embodiments is shown. In Fig. 7, the operation of some devices of the evaluation system with respect to time, T, is illustrated. The time, T, may be set by a timing unit. Image trigger signals 420 and/or illumination trigger signals 430 that are sent from a control unit of the evaluation system to the image capturing device and/or the illumination unit of the evaluation system are shown in the diagram. An image trigger signal 420 may comprise an image window signal. An illumination trigger signal 430 may comprise an illumination window signal 430. The diagram illustrates a timer signal/clock signal 410 generated by/set by a timer comprised in the control unit. The diagram in Fig. 7 further illustrates logging/storing 440 of e.g. evaluation data by the data storage of the evaluation system over time, T. The control unit of the evaluation system may be configured to run the timer. The control unit may be configured to send one of the at least one image trigger signal 420 and the at least one illumination trigger signal 430 based on the timer. As seen in the diagram in Fig. 7, the timer is initiated at t₁, an image trigger signal 420 in the form of one or more image window signals are sent from the control unit and received by the image capturing device at t₂, and an illumination trigger signal 430 in form of one or more illumination window signals are sent from the control unit and received by the illumination unit at t₃. The example operation comprises several image trigger signals 420 and illumination trigger signals 430 as seen in the diagram. As seen in Fig. 7, the logging/storing 440 of evaluation data by the data storage is carried out through the whole example operation. For example, the captured images, the image window signals 420 and the illumination window signals 430 may be logged/stored with references between them, the time, T, and other evaluation data obtained during the example operation.

In an example, the control unit may be configured to receive a position sequence comprising a set of target positions. The timer may be based on/initiated by the position sequence. For example, if positional data from a position sensor of the evaluation system indicates a target position in the position sequence, i.e. the position of the substrate relative the optical arrangement and/or the image capturing device corresponds to a target position in the position sequence, then the timer is initiated. The control unit may then be configured to send one of the at least one image trigger signal 420 and the at least one illumination trigger signal 430 based on the initiated timer.

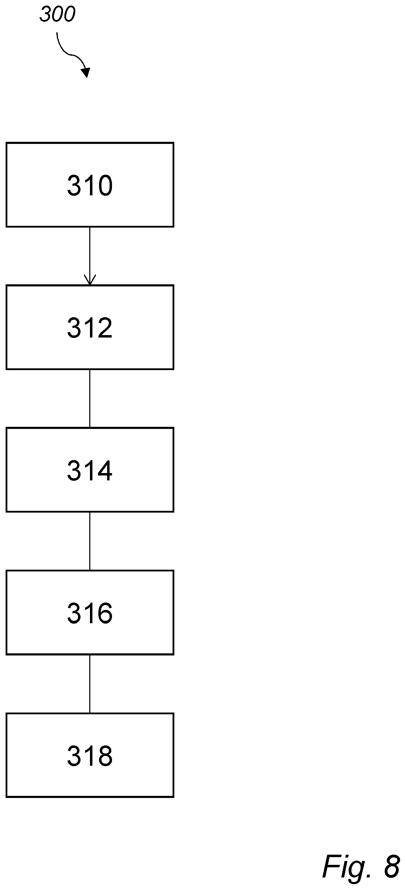

With reference to Fig. 8, a flowchart of a method 300 for evaluating a substrate 110 according to a second aspect of the invention is shown. The method 300 for evaluating a substrate 100 uses an evaluation system according to any embodiment of the first aspect of the invention. As seen in Fig. 7, the method 300 comprises performing 310 an imaging sequence. The imaging sequence comprises at least one image trigger signal and at least one illumination trigger signal. The method 300 comprises sending 312, from the control unit to the image capturing device, at least one image trigger signal. The method 300 comprises sending 314, from the control unit to the illumination unit, at least one illumination trigger signal. The method 300 comprises capturing 316, by the image capturing device, an image of a target position 112 on the substrate 110, via the optical arrangement, based on the at least one image trigger signal. The method 300 comprises illuminating 318, by the illumination unit, the target position 112 on the substrate 110, via the optical arrangement, based on the at least one illumination trigger signal.

Additionally, variations to the disclosed examples can be understood and effected by the skilled person in practicing the claimed invention, from a study of the drawings, the disclosure, and the appended claims. The mere fact that certain measures are recited in mutually different dependent claims does not indicate that a combination of these measures cannot be used to advantage.

A feature described in relation to one aspect may also be incorporated in other aspects, and the advantage of the feature is applicable to all aspects in which it is incorporated. Other objectives, features, and advantages of the present inventive concept will appear from the detailed disclosure, from the attached claims as well as from the drawings.

Generally, all terms used in the claims are to be interpreted according to their ordinary meaning in the technical field, unless explicitly defined otherwise herein. Further, the use of terms "first", "second", and "third", and the like, herein do not denote any order, quantity, or importance, but rather are used to distinguish one element from another. All references to "a/an/the [element, device, component, means, step, etc.]" are to be interpreted openly as referring to at least one instance of said element, device, component, means, step, etc., unless explicitly stated otherwise. The steps of any method disclosed herein do not have to be performed in the exact order disclosed, unless explicitly stated.

## Claims

1. An evaluation system (100) for evaluating a substrate (110), the evaluation system comprising:
at least one optical arrangement (120) configured to have a focal point at a target position (112) of the substrate,
an image capturing device (130) configured to capture at least one image of the target position of the substrate via the at least one optical arrangement,
an illumination unit (140) configured to illuminate the target position of the substrate via the at least one optical arrangement,
a control unit (150) configured to perform an imaging sequence,
wherein the imaging sequence comprises at least one image trigger signal and at least one illumination trigger signal, wherein the control unit is configured to send the at least one image trigger signal to the image capturing device and the at least one illumination trigger signal to the illumination unit,
wherein the image capturing device is configured to receive the at least one image trigger signal and capture at least one image based on the at least one image trigger signal, and wherein the illumination unit is configured to receive the at least one illumination trigger signal and to illuminate the substrate based on the at least one illumination trigger signal.

2. The evaluation system according to claim 1, wherein the at least one optical arrangement comprises an objective lens (122), and wherein the evaluation system comprises at least one position sensor (160) configured to generate positional data indicating a position of the objective lens relative to the substrate, and wherein the control unit is configured to receive the positional data from the at least one position sensor and perform the imaging sequence based on the positional data.

3. The evaluation system according to claim 2, wherein the at least one position sensor comprises at least one of an interferometer (162) and an encoder (164).

4. The evaluation system according to any one of the preceding claims, wherein the control unit is configured to run a timer (152), and wherein the control unit is configured to be triggered to send at least one of the at least one image trigger signal and the at least one illumination trigger signal based on the timer.

5. The evaluation system according to claim 4, wherein the control unit is configured to receive a position sequence comprising a set of target positions, and wherein the timer is based on the position sequence.

6. The evaluation system according to any one of the preceding claims, wherein the at least one image trigger signal comprises an image window signal, and wherein the at least one illumination trigger signal comprises an illumination window signal.

7. The evaluation system according to claim 6, wherein the image window signal and illumination window signal at least partially overlap in time.

8. The evaluation system according to any one of the preceding claims, wherein the illumination unit comprises a laser.

9. The evaluation system according to any one of the preceding claims, wherein the evaluation system comprises at least one secondary sensor (170), wherein the control unit is configured to receive sensor data from the at least one secondary sensor, and wherein the at least one secondary sensor comprises at least one of a pneumatic sensor, an optical sensor, an inductive sensor, an accelerometer and a temperature sensor.

10. The evaluation system according to any one of the preceding claims, wherein the evaluation system comprises a data storage (180) for storing evaluation data, wherein the evaluation data comprises at least one of the positional data, the sensor data, the at least one captured image, and log data of the at least one image trigger signal and the at least one illumination trigger signal.

11. The evaluation system according to claim 10, wherein the evaluation system is configured to determine at least one of a parameter and a condition of the substrate based on the evaluation data.

12. The evaluation system according to claim 10 or 11, wherein the evaluation system is configured to generate at least one processed image based on at least one of the evaluation data, the parameter and the condition.

13. The evaluation system according to any one of claims 10 to 12, wherein the evaluation system is configured to compare the evaluation data with predetermined data and generate comparison data, and to determine at least one of a parameter and a condition of the substrate based on the comparison data.

14. The evaluation system according to any one of the preceding claims, wherein the at least one optical arrangement comprises:
a first optical arrangement (124) arranged on a first side of the substrate, wherein the image capturing device is configured to capture the at least one image of the target position of the substrate via the first optical arrangement, and
a second optical arrangement (126) arranged on a second side of the substrate, wherein the illumination unit is configured to illuminate the target position of the substrate via the second optical arrangement,
wherein the second side is opposite the first side.

15. A method (300) for evaluating a substrate using an evaluation system comprising at least one optical arrangement, an image capturing device, an illumination unit and a control unit, the method comprising:
performing (310) an imaging sequence comprising the steps of:
sending (312), from the control unit to the image capturing device, at least one image trigger signal,
sending (314), from the control unit to the illumination unit, at least one illumination trigger signal,
capturing (316), by the image capturing device, an image of a target position of the substrate, via the at least one optical arrangement, based on the at least one image trigger signal,
illuminating (318), by the illumination unit, the target position of the substrate, via the at least one optical arrangement, based on the at least one illumination trigger signal.
